Europäisches Patentamt

European Patent Office

Office européen des brevets

(11) Publication number: **0 040 190**
**B1**

(12) **EUROPEAN PATENT SPECIFICATION**

(45) Date of publication of patent specification: **08.06.88**

(21) Application number: **80900008.6**

(22) Date of filing: **16.11.79**

(86) International application number:
**PCT/US79/00984**

(87) International publication number:
**WO 81/01494 28.05.81 Gazette 81/13**

(51) Int. Cl.⁴: **H 05 K 3/00, B 05 D 3/00,
B 05 D 3/02, B 05 D 3/12,
B 05 D 5/12, B 05 D 7/22,
C 23 C 24/08**

(54) **METHOD FOR METALIZING HOLES IN INSULATING MATERIAL.**

(43) Date of publication of application:
**25.11.81 Bulletin 81/47**

(45) Publication of the grant of the patent:
**08.06.88 Bulletin 88/23**

(84) Designated Contracting States:
**FR**

(56) References cited:
**EP-A-0 003 364**
**DE-B-1 223 910**
**FR-A- 659 676**
**FR-A-1 357 600**
**GB-A- 1 243**
**GB-A-1 094 447**
**US-A-3 158 503**
**US-A-3 268 653**
**US-A-3 357 856**
**US-A-3 391 455**
**US-A-3 416 958**
**US-A-3 562 009**
**US-A-3 576 669**

(73) Proprietor: **LOMERSON, Robert Bogardus**
**Route 9, Box 196**
**Fort Worth, TX 76106 (US)**

(72) Inventor: **LOMERSON, Robert Bogardus**
**Route 9, Box 196**
**Fort Worth, TX 76106 (US)**

(74) Representative: **Murgitroyd, Ian G. et al**
**Murgitroyd and Company Mitchell House 333
Bath Street
Glasgow G2 4ER (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical Field

This invention relates to the manufacture of electronic circuit boards and more particularly to the metalizing of holes to form a conducting path through circuit boards.

Background Art

In the prior art to produce a through-the-board conducting path in a printed circuit board having layers of copper on both sides, the board is first passed through a drilling operation wherein all of the holes to be utilized as conductive holes throught the board are drilled. Thereafter, a series of steps are taken in which a heavy layer of copper is ultimately deposited on the walls of each of the holes. This is done by first subjecting it to a catalyst seeding operation wherein micro-deposits of metal are placed on the walls of each of the holes. Thereafter, copper is plated out onto the walls of the holes. After all of the holes have thus been plated, the printed circuit pattern is laid out on the two sides of the board and the copper is etched leaving the lead path intact. Thereafter the components are mounted on the circuit board and a soldering step completes the task of securing the component to the board. The holes containing leads to the components are then filled with solder.

In U.S. Patent No. 3,576,669 the walls of a through hole are coated by passing a rod through the hole and immersing the rod in a liquid metal mixture. The liquid metal adheres to the rod and as the rod is withdrawn from the circuit board the liquid metal is coated onto the walls of the hole. The liquid metal then hardens at room temperature and produces a conducting path between the two sides of the circuit board.

The present invention eliminates many of the foregoing steps. The copper-clad circuit board may be drilled and etched with these operations occurring in any order. The chemical baths and metal deposition steps are minimized. The drilling operation itself results in the hole surfaces being wiped with conductive cuttings to cover the entire surface with a conductive layer.

Thereafter the components may be mounted onto the board and wave soldered to fill the holes with solder. The soldering operation is enhanced and made possible at the sites of the holes by reason of the metal coating on the inner walls of the holes.

GB—A—1 094 447 discloses a method of forming a passage with a conductive layer on the wall thereof, using a specially shaped punch or specially grooved drill to carry an emulsion of a powdered conductor (graphite) in a liquid (water).

EP—A—0 003 364 discloses a method of forming conductive paths by applying finely divided metallic or alloy particles to adherent surfaces and subsequently conjoining the particles by burnishing.

The present invention, which is characterized in Claim 1, makes it possible to drill a passage and render it conductive in a single and simple operation not involving liquids and subsequent drying steps, or the use of adhesives and associated process steps.

Brief Description of the Drawings

The novel features believed characteristic of the invention are set forth in the appended claims. The invention itself, however, as well as further objects and advantages thereof, will best be understood by reference to the following detailed description of an illustrative embodiment taken in conjunction with the accompanying drawings in which:

Figure 1 is a side view of a drill bit, printed circuit board and conductive material plate; and

Figure 2 is a side view of circular saw blade, a printed circuit board and a conductive material plate.

Detailed Description

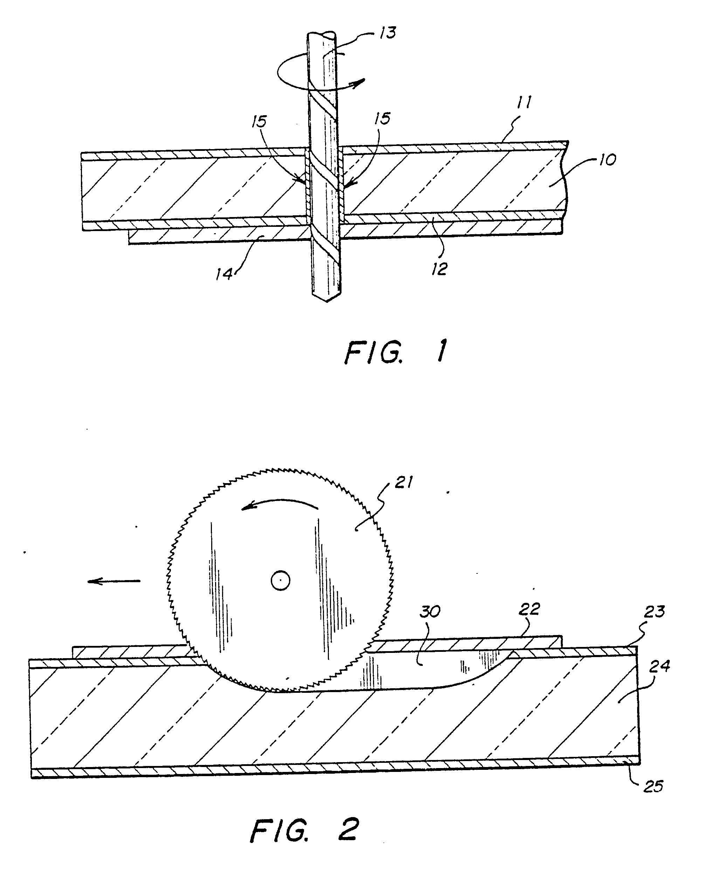

Referring now to Figure 1, drill bit 13 is passed through a printed circuit board consisting of copper layer 11, insulating block 10, copper layer 12, and through conductive material block 14. Conductive layer 15 is smeared onto the wall surface of the hole by the turning of drill bit 13.

Referring now to Figure 2, circular saw 21 is cut through conductive material block 22, copper layer 23 and insulating plate 24. The cuttings from conductive material block 22 are smeared onto the walls of plate 24 creating a conductive surface 30.

In operation, referring to Figure 1, the drill bit 13 is forced through the printed circuit board layers 10, 11 and 12, and then into contact with the conductive material block 14. Upon contacting the conductive material, cuttings are produced which are carried upward by the drill bit. These conductive material cuttings are carried into the hole in the printed circuit board and are smeared onto the surface walls of the hole by the turning of the drill bit. The tendency of the drill bit to propel the cuttings upward results in the coating of the entire surface of the hole with the conductive material. The drill bit is then withdrawn leaving a layer of conductive material which has been smeared on the surface of the hole walls. The smeared conductive surface is in contact with both of the metal layers of the printed circuit board thus establishing an electrically conductive path between the two layers.

Similarly, in Figure 2, as saw blade 21 cuts through conductive material block 22, copper layer 23 and insulating plate 24, a groove is cut along the surface of the printed circuit board. The cuttings from the conductive material block 22 are carried along by saw 21 into the groove. These cuttings are then smeared by the blade onto the groove walls of the insulating plate. This conductive surface 30 is in contact with copper layer 23. Thus grooves can be cut in the surface of the printed circuit board to establish electrically conductive paths from one point to another.

In like fashion, saw blade 21 could cut completely through plate 24 and copper layer 25 to establish a conductive path from one side of the printed circuit board to another.

The formation of the layer of conductive material on the walls of the holes is not fully understood. In the case of an indium alloy, it is known that indium will wet insulatig materials such as glass epoxy. Because of this property, indium alloys are used to bond to glass and epoxy. Using an indium alloy in accordance with the present invention may therefore depend upon the affinity of the indium itself to an insulator, and its compatibility with conventional solders permits its use for the present purpose. In such case, the alloy may not need to be worked to a melting temperature in order to establish the layer.

In other metals of low melting point, but not indium alloys, and thus not of the type which will wet glass or epoxy, the layer of such metal is spread onto the walls of the hole by the mechanical working of the bit such that the melting temperature or near melting temperature is approached in which state the layer of conductive material is smeared or frictionally applied onto the hole walls.

In accordance with the present invention, either type of conductive material can be used. In one case, an indium-tin alloy (50—50) was found to be suitable. In another case, a bismuth, cadmium tin and lead alloy was employed (50%, 10%, 13.3%, 26.7%).

In one instance, a drill bit forming the hole was passed through the insulating board and into an adjacent underlying layer of the desired alloy. The cuttings from the underlying layer drawn through the hole in the insulating board was then effectively wiped onto the hole walls to coat the same.

In another operation, the same effect was produced by passing the drill bit first through a layer of the coating material and then through the insulating board.

It will be understood that while copper clad insulating circuit boards are generally employed and are desired because of the ability to solder to copper, other circuit board metals may be employed. For example, aluminium may be employed as the basic conductor on the face of the circuit boards. In such case, a metal would be used to coat the holes which is compatible with aluminum. A low melting point fusable indium alloy is suitable for such arrangement.

Further, in some instances it may be desirable to utilize the fusable alloy as the plating on the circuit board itself so that after the plating has been etched to form the desired circuit paths, holes drilled through the low melting point metal forming the circuit paths and thence through the circuit board and into a similar path on the other side of the circuit board would automatically result in the coating of the hole. This would be done without utilization of a separate layer of material for applying the coating metal.

Various types of cutting tools can be employed to cut the insulating plate and the plate can be cut in various ways. The plate can be drilled to form a conductor from one surface to another, a groove can be cut through to connect two points on one surface or the groove can cut through the plate to connect both surfaces. Thus, the term "through" means any geometry of cutting of the insulating plate to form a conductive path.

The embodiment of this invention previously described used the spreadable and conductive material in block form but the invention is not limited to this form. The conductive material can also be used in subdivided forms such as cuttings or powder.

While embodiments of the invention have been described in detail, modifications and alterations may occur to others upon a reading and understanding of the specification.

## Claims

1. A method for establishing an electrically conductive path on the surface of a passage through a non-conductive body, the method comprising forcing a mechanically spreadable and electrically conductive material into frictional contact with the wall of said passage to form a continuous layer of said material adhering to said wall wherein said material is in the form of a subdivided solid, and characterised in that said material is transported into the passage and smeared onto the wall thereof by operation of a tool moving with respect to said wall.

2. The method of claim 1 wherein said tool is a cutting tool which is passed through said body to form said passage.

3. The method of claim 1 or claim 2 wherein said material is in the form of metallic cuttings.

4. The method of claim 2 or claim 3 wherein said material is juxtaposed with the non-conductive body, is deposited on said tool prior to the formation of said passage and is smeared onto the wall thereof by operation of the tool during the formation of said passage.

5. The method of claim 2 or claim 3 wherein said material is juxtaposed with the non-conductive body, is deposited on said tool after said passage has been formed and is smeared onto the wall thereof by continued operation of said tool.

6. The method of any preceding claim in which said material is melted by frictional heat produced by said tool.

7. The method of any of claims 2 to 6, in which said cutting tool is a circular saw blade.

8. The method of any of claims 2 to 6, in which said cutting tool is a circular saw blade.

9. The method of any preceding claim, including the further step of plating a second conductive metal onto the surface of said layer.

## Patentansprüche

1. Verfahren zum Herstellen eines elektrisch leitfähigen Weges an der Fläche eines Durchlasses durch einen nichtleitfähigen Körper, bei dem ein mechanisch ausbreitbares und elektrisch leitfähiges Material in Reibkontakt mit der Wand des Durchlasses gedrückt wird, um eine durchgehende Schicht des an der Wand anhaftenden Materials zu bilden, wobei das Material die Form eines unterteilten Festkörpers aufweist, und dadurch gekennzeichnet, daß das Material in den Durchlaß transportiert wird und durch Betätigung eines sich im Verhältnis zur Wand bewegenden Werkzeuges auf die Wand des Durchlasses gerieben wird.

2. Verfahren nach Anspruch 1, bei dem das Werkzeug ein Schneidwerkzeug ist, das zum Bilden des Durchlasses durch den Körper geführt wird.

3. Verfahren nach Anspruch 1 oder 2, bei dem das Material aus Metallschneidspänen besteht.

4. Verfahren nach Anspruch 2 oder Anspruch 3, bei dem das Material dem nichtleitfähigen Körper gegenüber angeordnet wird, vor dem Bilden des Durchlasses auf das Werkzeug aufgetragen wird und durch Betätigung des Werkzeugs während des Bildens des Durchlasses an die Wand des Durchlasses gerieben wird.

5. Verfahren nach Anspruch 2 oder Anspruch 3, bei dem das Material dem nichtleitfähigen Körper gegenüber angeordnet wird, auf das Werkzeug aufgetragen wird, nachdem der Durchlaß gebildet worden ist, und durch fortgesetzte Betätigung des Werkzeugs an die Wand des Durchlasses gerieben wird.

6. Verfahren nach einem der vorhergehenden Ansprüche, bei dem das Material mittels von dem Werkzeug erzeugter Reibeungswärme geschmolzen wird.

7. Verfahren nach einem der Ansprüche 2 bis 6, bei dem das Schneidwerkzeug ein Bohrer ist.

8. Verfahren nach einem der Ansprüche 2 bis 6, bei dem das Schneidwerkzeug ein Kreissägeblatt ist.

9. Verfahren nach einem der vorhergehenden Ansprüche, mit dem weiteren Schritt des Plattierens eines zweiten leitfähigen Metalls auf die Oberfläche der Schicht.

**Revendications**

1. Procédé pour établir un trajet électriquement conducteur sur la surface d'un passage à travers un corps non-conducteur, le procédé consistant à forcer un matériau mécaniquement étalable et électriquement conducteur en contact de friction avec la paroi du dit passage pour former une couche continue du dit matériau adhérant à la dite paroi dans lequel le dit matériau est sous la forme d'un solide subdivisé, et caractérisé en ce que dit matériau est transporté dans le passage et est enduit sur la paroi de celui-ci par le fonctionnement d'un outil se déplaçant par rapport à la dite paroi.

2. Procédé suivant la revendication 1 dans lequel le dit outil est un outil de coupe qui est passé à travers le dit corps pour former le dit passage.

3. Procédé suivant la revendication 1 ou la revendication 2 dans lequel le dit matériau est sous la forme de débris métalliques.

4. Procédé suivant la revendication 2 ou la revendication 3 dans lequel le dit matériau est juxtaposé avec le corps non-conducteur, est déposé sur le dit outil avant la formation du dit passage et est enduit sur la paroi de celui-ci par le fonctionnement de l'outil durant la formation du dit passage.

5. Procédé suivant la revendication 2 ou la revendication 3 dans lequel le dit matériau est juxtaposé avec le corps non-conducteur, est déposé sur le dit outil après que le dit passage ait été formé et est enduit sur la paroi de celui-ci par la poursuite du fonctionnement du dit outil.

6. Procédé suivant l'une quelconque des revendications précédentes dans lequel le dit matériau est fondu par la chaleur de frottement produite par le dit outil.

7. Procédé suivant l'une quelconque des revendications 2 à 6 dans lequel le dit outil de coupe est un forêt de perçage.

8. Procédé suivant l'une quelconque des revendications 2 à 6 dans lequel le dit outil de coupe est une lame de scie circulaire.

9. Procédé suivant l'une quelconque des revendications précédentes comprenant la phase supplémentaire consistant à plaquer un second métal conducteur sur la surface de la dite couche.

0 040 190

FIG. 1

FIG. 2